# DEMANDE DE BREVET EUROPEEN

(11) **EP 1 249 905 A1**
(43) Date de publication de la demande: **16.10.2002**
(21) Numéro de dépôt: 01810353.1
(22) Date de dépôt: 10.04.2001
(51) Int. Cl.: H01S 5/34, H01S 5/028

(54) **Laser semi-conducteur muni d'un miroir**

(71) Demandeur: Alpes Lasers SA, 2000 Neuchâtel (CH)
(72) Inventeur: Faist, Jérôme, 2000 Neuchâtel (CH); Hofstetter, Daniel, 2000 Neuchâtel (CH); Aellen, Thierry, 2114 Frleurier (CH)
(74) Mandataire: Gresset, Jean

(57) **Abrégé**

Laser semi-conducteur, de type inter sous-bandes, comportant un substrat (10) en matériau semi-conducteur, un empilement de couches en matériaux semi-conducteurs également, disposé sur le substrat et formant une cavité active (12) dans laquelle est généré le rayonnement laser, ladite cavité étant munie de deux faces planes et parallèles (12a), au travers desquelles le rayonnement est émis à une longueur d'onde définie par les caractéristiques dudit empilement, l'une d'elles au moins étant revêtue d'un miroir (18), ladite cavité (12) portant une couche électriquement conductrice (14), laquelle forme, avec ledit substrat (10), deux électrodes entre lesquelles est appliquée une tension électrique engendrant un courant qui induit le rayonnement laser,

Dans ce laser, le miroir (18) comporte une strate de matériau transparent pour la longueur d'onde considérée, présentant un indice de réfraction sensiblement plus élevé que celui des matériaux formant ladite cavité, par exemple en sel de plomb.

## Description

La présente invention se rapporte aux lasers semi-conducteurs. De tels lasers comportent un substrat en matériau semi-conducteur, sur lequel est disposé un empilement de couches en matériaux semi-conducteurs également, formant une cavité active, dans laquelle est généré le rayonnement laser. Cette cavité comporte deux faces planes et parallèles, au travers desquelles le rayonnement est émis, à une longueur d'onde définie par les caractéristiques de l'empilement. En outre, la cavité est disposée sur le substrat et porte une couche électriquement conductrice, le substrat et la couche conductrice formant deux électrodes entre lesquelles est appliquée une tension électrique engendrant un courant qui induit le rayonnement laser, par transition inter bandes ou inter sous-bandes. L'une au moins des faces est revêtue d'un miroir. Dans la présente demande, on appelle miroir une couche, formée d'une ou plusieurs strates métalliques, semi-conductrices ou diélectriques, et qui réfléchit tout ou partie d'un rayon incident.

Ce type de laser émet un rayonnement à partir d'un certain niveau minimum de courant, appelé courant de seuil, d'autant plus bas que les faces de la cavité réfléchissent fortement la lumière émise sous l'effet du courant, comme le montre la publication de D. Coblenz et al. intitulée "Strained multiple quantum well lasers emitting at 1,3 µm grown by low-pressure metalorganic vapor phase epitaxy" et publié dans Appl. Phys. Lett. 59 (4), 22 juillet 1991.

Dans les lasers dont les extrémités ne portent pas de miroir, le taux de réflexion est de l'ordre de 22%.

Il est connu de réaliser des lasers inter sous-bandes, émettant dans l'infrarouge moyen, et munis d'un miroir formé d'une strate métallique disposée sur l'une des faces de la cavité, avec interposition d'une strate diéléctrique. Un tel laser est décrit dans la publication de C. Gmachl, A.M. Sergent, A. Tredicucci, F. Capasso, A.L. Hutchinson, D.L. Sivco, J.N. Baillargeon, S.N.G. Chu, and A.Y. Cho, intitulé "Improved CW operation of quantum cascade lasers with epitaxial-side heat-sinking" qui a paru dans IEEE Photonics Technol. Lett., 11(11), pp. 1369 - 1371, 1999.

Une telle solution permet d'obtenir une bonne réflexion avec le dépôt de deux couches seulement. Toutefois, ce type de miroir ne laisse pas du tout passer de lumière. Il ne peut en conséquence être utilisé que sur l'une des faces de la cavité, l'autre permettant l'émission du rayonnement. Par ailleurs, il existe un risque de produire des courts-circuits, spécialement entre les deux électrodes.

Il est également connu de réaliser des lasers semi-conducteurs inter bandes, qui émettent de la lumière dans l'infrarouge proche ou dans le visible, et qui sont munis de miroirs formés d'une couche semi-conductrice et semi-réfléchissante. Pour un laser dont la longueur d'ondes d'émission est de 400 nm par exemple, on peut obtenir un taux de réflexion d'environ 50% en utilisant un empilement de deux paires de strates SiO₂/TiO₂. Un tel laser a été décrit dans la publication de S. Nakamura, M. Senoh, S. Nagahama, N. Iwasa, T. Yamada, T. Matsushita, H. Kiyoku, Y. Sugimoto, T. Kozaki, H. Umemoto, M. Sano, and K. Chocho intitulé "InGaN/GaN/AlGaN-based laser diodes with cleaved facets on GaN substrates" qui est publié dans Appl. Phys. Lett., 73(6), pp. 832-834, 1998.

Dans les lasers inter bandes, il n'est pas possible d'utiliser des matériaux présentant un indice de réfraction plus élevé, ceux-ci n'étant pas transparents pour la longueur d'onde du rayonnement laser. Il en résulte que, pour augmenter le taux de réflexion, il est nécessaire de multiplier les strates. Cela implique de nombreuses opérations successives. De plus, des tensions mécaniques à l'intérieur de celles-ci peuvent engendrer des problèmes d'adhérence.

Ces solutions sont, sans autre, applicables aux lasers semi-conducteurs de type inter sous-bandes, avec les mêmes avantages et les mêmes inconvénients.

Le but de la présente invention est de permettre la réalisation d'un laser semi-conducteur de type inter sous-bandes, qui ne présente pas ces inconvénients. A cet effet, le miroir comporte une strate de matériau transparent pour la longueur d'onde considérée, présentant un indice de réfraction sensiblement plus élevé que celui des matériaux formant la cavité. De manière typique, cet indice est égal ou supérieur à 3.5. On entend ici par transparent, un matériau qui, dans les épaisseurs considérées - de l'ordre de la moitié de la longueur d'onde du rayonnement laser - présente un taux d'absorption qui ne dépasse pas quelques pour cents.

Afin de réduire le plus possible le courant de seuil, les deux faces d'extrémité sont revêtues d'un miroir.

Une telle structure est particulièrement bien adaptée aux lasers dont la cavité est agencée de manière à ce que le rayonnement présente une longueur d'onde comprise dans l'infrarouge moyen et que le matériau transparent est un sel de plomb, et plus particulièrement lorsque ce sel est un sulfure, un tellurure ou un séléniure de plomb. Il est en effet apparu que, malgré la grande différence des caractéristiques physiques et chimiques des sels de plomb avec les matériaux constituant l'empilement, l'adhérence obtenue est très bonne. De plus, dans le cas des lasers de type inter sous-bandes, un tel matériau, malgré son haut indice de réfraction, est transparent pour la longueur d'onde du rayonnement émis.

Dans de tels lasers, il est parfois souhaitable d'avoir un rayonnement de type mono-mode. Ce résultat est obtenu en créant dans la cavité ou à sa périphérie, une structure périodique correspondant à la longueur d'onde désirée. La pratique a montré que, pour avoir effectivement un seul mode, il fallait, de plus, engendrer une dissymétrie dans la cavité. Celle-ci peut avantageusement être obtenue en ne disposant un miroir que sur l'une des faces, ou en utilisant des miroirs présentant des caractéristiques différentes.

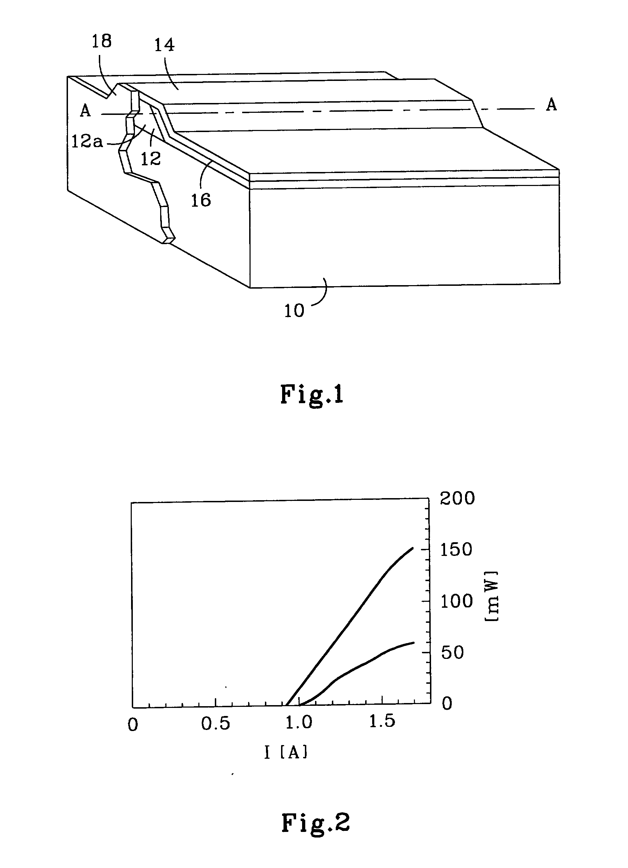

D'autres avantages et caractéristiques de l'invention ressortiront de la description qui va suivre, faite en regard du dessin annexé, dans lequel:
■ La figure 1 représente, en perspective et de manière schématique, un laser selon l'invention, et
■ La figure 2 est un diagramme comparatif du fonctionnement d'un laser de type inter sous-bandes muni ou non d'une couche réfléchissante selon l'invention.

Le laser représenté sur la figure 1 comporte un substrat 10, généralement en InP dopé, sur lequel sont disposées des couches successives d'InGaAs et de AllnAs, formant ensemble une cavité active 12 comportant une région de gain comprise entre deux couches de confinement, qui n'ont pas été représentées pour éviter de surcharger le dessin.

La cavité active 12 est de forme prismatique hexaédrique à section trapézoïdale dont une face, qui définit la grande base du trapèze, est en contact avec le substrat 12. Elle comporte deux faces d'extrémités 12a, parallèles entre elles et perpendiculaires à la face du substrat portant la cavité 12. Cette dernière est agencée pour émettre un rayonnement laser selon un axe A-A perpendiculaire aux faces d'extrémités 12a. Ce rayonnement sort par l'une ou l'autre de ces faces.

Le substrat 10 porte une électrode 14 qui recouvre, en outre, au moins partiellement la face de la cavité 12 formant le petit côté du trapèze, une couche isolante 16 étant interposée entre le substrat 10 et l'électrode 14. De manière classique, le rayonnement laser est obtenu par l'application d'une tension électrique continue de quelques volts entre l'électrode 16 et le substrat 10, laquelle engendre un courant dans la cavité active 12.

De tels lasers, décrits par exemple par D. Hofstetter, T. Aellen, M. Beck, et J. Faist dans Appl. Phys. Lett., vol. 78, no.4, pp. 396 - 398, 2001 émettent dans l'infrarouge moyen, la longueur d'onde étant typiquement de 10 µm.

Les faces d'extrémités 12a portent une couche 18 partiellement arrachée sur la figure 1, et faite d'une strate de matériau diélectrique tel qu'un tellurure de plomb, d'une épaisseur de l'ordre de 500 nm, ce qui correspond sensiblement à un quart de la longueur d'onde du laser considéré. Une telle couche, transparente pour une longueur d'onde de 10 µm, présente un indice de réfraction n = 5. Elle permet de faire passer la réflectivité de 22 à 55%. Il est aussi possible de remplacer le tellurure de plomb par un séléniure ou par un sulfure de plomb par exemple, ces matériaux présentant des caractéristiques optiques tout à fait comparables.

L'expérience a montré que ces matériaux, qui sont transparents dans l'infrarouge moyen, peuvent être déposés par évaporation thermique sous vide depuis un creuset en molybdène. Les conditions d'adhérences sont bonnes, à cause notamment de la faible épaisseur qui fait que les tensions internes de cisaillement sont négligeables.

Le diagramme de la figure 2 représente, en abscisse, la valeur du courant, et en ordonnée, la puissance fournie par un laser de 1,5 mm de long, en A ne comportant pas de couche réfléchissante et en B muni d'une couche de PbTe de 485 nm sur chacune de ses faces 12a.

La présence des couches réfléchissantes permet de réduire de manière sensible le courant de seuil, puisqu'il passe 1.01 A à 0.92 A. En outre, le rapport entre la puissance fournie et le courant dissipé augmente d'un facteur 1.8.

Il est, par ailleurs, possible de réaliser dans la cavité 12, ou à son voisinage immédiat, une structure périodique permettant d'engendrer un rayonnement mono-mode. Un tel laser est décrit dans le document WO 00/59085

Avec une telle structure et en munissant le laser d'une couche 18 à l'une au moins de ses extrémités, le rapport d'extinction des modes voisins passe de 12 à 27 dB, soit une croissance de près de deux ordres de grandeur.

Le taux de réflexion peut être encore augmenté en déposant, sur la première strate de sel de plomb, une strate de matériau à faible indice de réfraction, par exemple du SiO₂, d'épaisseur sensiblement égale à un quart de la longueur d'onde du rayonnement laser, puis une nouvelle strate de matériau à fort indice de réfraction, en l'occurrence du sel de plomb, comme défini ci-dessus, d'épaisseur sensiblement égale à un quart de la longueur d'onde du rayonnement laser.

Pour certaines applications, il est nécessaire de disposer d'un rayonnement de type mono-mode. Ce résultat est obtenu en créant, dans la cavité ou à sa périphérie, une structure périodique correspondant à la longueur d'onde désirée. La pratique a montré que, pour avoir effectivement un seul mode, il faut, de plus, engendrer une dissymétrie dans la cavité. Cette dissymétrie peut être obtenue en ne disposant un miroir que sur l'une des faces ou en utilisant des miroirs qui présentent des caractéristiques différentes. Dans ce dernier cas, les couches formant miroir comportent un nombre différent de strates. De la sorte, avec un nombre de strates très restreint, il est possible d'améliorer sensiblement, de manière simple et économique, le rendement des lasers semi-conducteurs travaillant dans l'infrarouge, et plus particulièrement dans l'infrarouge moyen.

## Revendications

1. Laser semi-conducteur, de type inter sous-bandes, comportant un substrat (10) en matériau semi-conducteur, un empilement de couches en matériaux semi-conducteurs également, disposé sur le substrat et formant une cavité active (12) dans laquelle est généré le rayonnement laser, ladite cavité étant munie de deux faces planes et parallèles (12a), au travers desquelles le rayonnement est émis à une longueur d'onde définie par les caractéristiques dudit empilement, l'une d'elles au moins étant revêtue d'un miroir (18), ladite cavité (12) portant une couche électriquement conductrice (14), laquelle forme, avec ledit substrat (10), deux électrodes entre lesquelles est appliquée une tension électrique engendrant un courant qui induit le rayonnement laser,
**caractérisé en ce que** ledit miroir (18) comporte une strate de matériau transparent pour la longueur d'onde considérée, présentant un indice de réfraction sensiblement plus élevé que celui des matériaux formant ladite cavité.

2. Laser selon la revendication 1, **caractérisé en ce que** les deux faces d'extrémité (12a) sont revêtues de ladite strate.

3. Laser selon l'une des revendications 1 et 2, **caractérisé en ce que** ladite cavité (12) est agencée de manière à ce que ledit rayonnement présente une longueur d'onde comprise dans l'infrarouge moyen et que ledit matériau transparent est un sel de plomb.

4. Laser selon la revendication 4, **caractérisé en ce que** ledit sel est un sulfure, un tellurure ou un séléniure de plomb.

5. Laser selon l'une des revendications 1 à 4, **caractérisé en ce que** ladite cavité est agencée de manière à ce qu'elle émette un rayonnement mono-mode et que lesdites faces sont chacune munies d'un miroir (18), lesquels présentent des caractéristiques de réflexions différentes.

6. Laser selon l'une des revendications 1 à 4, **caractérisé en ce que** ladite cavité est agencée de manière à ce qu'elle émette un rayonnement mono-mode et que l'une des faces seulement est revêtue d'un miroir (18).
